Europäisches Patentamt

European Patent Office

Office européen des brevets

(11) Publication number: **0 104 559**
**B1**

(12) **EUROPEAN PATENT SPECIFICATION**

(45) Date of publication of patent specification: **06.08.86**

(21) Application number: **83109194.7**

(22) Date of filing: **16.09.83**

(51) Int. Cl.⁴: **C 30 B 15/14,** C 30 B 15/36,
C 30 B 15/22, C 30 B 27/02

(54) **Pulling method of single crystals.**

(30) Priority: **24.09.82 JP 167423/82**

(43) Date of publication of application:
**04.04.84 Bulletin 84/14**

(45) Publication of the grant of the patent:
**06.08.86 Bulletin 86/32**

(84) Designated Contracting States:
**DE FR GB**

(56) References cited:
**FR-A-1 409 118**
**FR-A-1 435 250**
**US-A-3 795 488**

(73) Proprietor: **SUMITOMO ELECTRIC INDUSTRIES LIMITED**
**No. 15, Kitahama 5-chome Higashi-ku**
**Osaka-shi Osaka 541 (JP)**

(72) Inventor: **Kotani, Toshihiro**
**Sumitomo Electric Ind. Ltd. Osaka Works**
**1-3, Shimaya 1-chome Konohana-ku Osaka (JP)**

(74) Representative: **Kuhnen, Wacker & Partner**
**Schneggstrasse 3-5 Postfach 1729**
**D-8050 Freising (DE)**

## Description

The invention relates to a method for pulling Single Crystals by the Czochralski technique.

In particular this invention relates to manufacturing of single crystals by such techniques as CZ (Czochralski) method and LEC (Liquid Encapsulated Czochralski) method, and especially to a method of controlling the temperature of separately controlled heaters used in the above methods.

An apparatus of a well known method according to the LEC method comprises a chamber, wherein a raw material in a crucible is melted under a layer of $B_2O_3$ glass by heating with a heater, a seed crystal is dipped below the surface of the melt, and then a single crystal is pulled up using the seed crystal. In this method, the controlling of the temperature of the heater is essential in order to obtain the desired temperature distribution in the chamber, especially to maintain a small and constant temperature gradient across the solid-liquid interface, that is, the borderline between the solid part and liquid part, during pulling of the single crystal. An example of such a setup can be seen in JP—A—52 39787.

In the case that the apparatus has only one heater, the single crystal is cooled rapidly by the convection of high-pressure gas in the chamber just after the single crystal comes out of the $B_2O_3$ melt, and the temperature gradient across the solid-liquid interface increases. As a result, the dislocation density of the single crystal increases, especially at the tail end of the crystal.

A new method has been developed for alleviating the above-mentioned problem. The furnace of this method consists of two heaters, i.e. a lower heater for heating the material melt and an upper heater for heating the $B_2O_3$ melt and pulled-up single crystal in order to maintain a small and constant temperature gradient across the solid-liquid interface while the crystal is being pulled up. Examples of such a setup can be seen in JP—A—5628872, JP—A—5413470 and JP—A—5711897.

In this case the temperature distribution in the furnace chamber is controlled by measuring the temperatures at certain points by thermocouples.

In other words, during pulling, the temperature of the lower heater is decreased gradually according to a temperature program, while the temperature of the upper heater is kept constant or changed only slightly. Therefore, the temperature of the single crystal is not directly controlled, but influenced by radiation heat from the upper heater by thermal conduction from the melt, and by cooling by convection of the gas in the chamber.

As mentioned above, the method using separate heaters enables maintaining a small and constant temperature gradient across the solid-liquid interface during pulling, but the control method using thermocouples placed outside the heaters is not sufficient for optimum control of the temperature gradient across the solid-liquid interface. Accordingly, the above method cannot avoid such defects as increasing the dislocation density of the single crystal and causing damage by vaporizing the volatile components (such as As and P).

It is the object of this invention to provide a method for solving the above-mentioned problems, that is, a method whereby it is easy to maintain a small and constant temperature gradient across the solid-liquid interface, to obtains a single crystal with low dislocation density throughout the crystal, and to reduce vaporization of the volatile components.

This invention is a method for pulling single crystals by the CZ or LEC technique, using a single-crystal pulling apparatus having a furnace consisting of separately controlled heaters, wherein the temperature at the seed holder is measured or monitored and power is supplied to the heaters so that the temperature difference between the crucible and the seed holder follows a predetermined pattern as a function of the pulled-up length of the crystal.

Although the seed holder may have been considered as a place for monitoring the temperature, it was never put into practice.

The seed holder is the most appropriate place for monitoring the temperature of the crystal during pulling because it is located near the pulled crystal and contacts it thermally in a direct way. Monitoring the temperature of the high-pressure gas around the crystal is not suitable because the temperature distribution is large and unstable.

The method of this invention is applicable to single crystals composed of III—V compounds, II—VI compounds, mixtures of them, Si semiconductors, Ge semiconductors, oxides, nitrides, and carbides which are pulled by means of the CZ method or LEC method.

Brief description of drawings

Figure 1 is a cross section of a conventional case wherein a single heater is used;

Figure 2 is a cross section of a case wherein two heaters are used;

Figure 3 is a cross section of a case wherein this invention is applied;

Figure 4a is a schematic representation of the temperature control technique;

Figure 4b is an illustration of the temperature difference between the crucible and seed holder as a function of pulled distance, in the case that this invention is applied;

Figure 4c shows changes of temperature; and

Figure 5 is an illustration of etch pit densities at the front part and tail part of the grown single crystal, wherein 5a and b correspond to conventional methods, and 5c corresponds to the method of this invention.

1 ... crucible;
2, 12, 22 ... furnaces;
3 ... raw material melt;

4 ... $B_2O_3$ melt;

5 ... seed crystal;

6 ... single crystal;

7, 23, 47 ... upper heaters;

8, 24, 43 ... lower heaters;

9, 10, 28, 29 ... thermocouples;

11 ... seed holder;

25, 26, 27 ... temperature monitoring points;

41, 45 ... automatic temperature controllers;

42 ... base program for controlling temperature of lower heater;

46 ... program for controlling temperature of upper heater.

Description of prior art

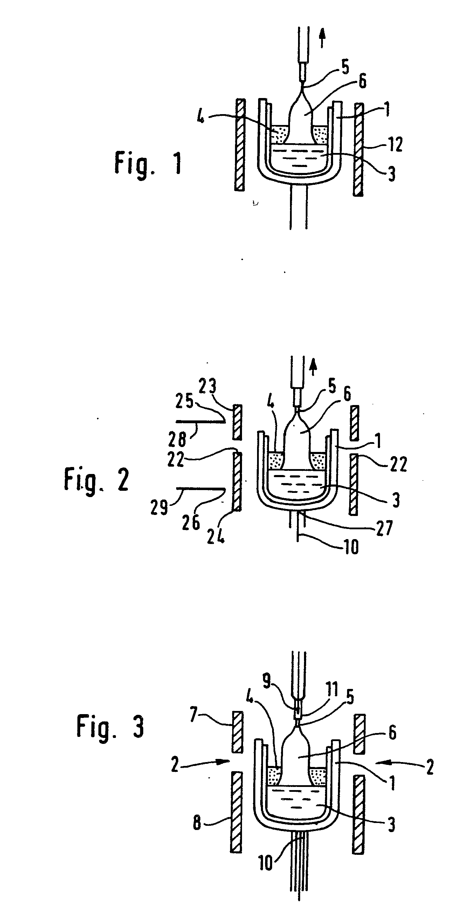

Figure 1 shows a schematic structure inside the chamber in the LEC method, wherein a raw material 3 in a crucible 1 is melted under a layer of $B_2O_3$ glass 4 by heating with a heater 12, a seed crystal 5 is dipped below the surface of the melt 3, and then a single crystal 6 is pulled up using the seed crystal 5. In this method, the controlling of the temperature of the heater is essential in order to obtain the desired temperature distribution in the chamber, especially to maintain a small and constant temperature gradient across the solid-liquid interface, that is, the borderline between the solid part and liquid part, during pulling of the single crystal. An example of such a setup can be seen in JP—A—5239787.

In the case that the apparatus has only one heater 12, as shown in Figure 1, the single crystal 6 is cooled rapidly by the convection of high-pressure gas in the chamber just after the single crystal comes out of the $B_2O_3$ melt 4, and the temperature gradient across the solid-liquid interface increases. As a result, the dislocation density of the single crystal increases, especially at the tail end of the crystal.

A new method has been developed for alleviating the above-mentioned problem. As shown in Figure 2, the furnace 22 consists of two heaters 23 and 24, i.e. a lower heater 24 for heating the material melt 3 and an upper heater 23 for heating the $B_2O_3$ melt 4 and pulled-up single crystal 6—in order to maintain a small and constant temperature gradient across the solid-liquid interface while the crystal is being pulled up. Examples of such a set-up can be seen in JP—A—5628872, JP—A—5413470 and JP—A—5711897.

In the case shown in Fig. 2, the temperature distribution in the furnace chamber is controlled by measuring the temperatures at points 25, 26, and 27 by thermocouples 28, 29, and 10, respectively. In other words, during pulling, the temperature of the lower heater 24 is decreased gradually according to a temperature program, while the temperature of the upper heater 23 is kept constant or changed only slightly. Therefore, the temperature of the single crystal 6 is not directly controlled, but influenced by radiation heat from the upper heater 23, by thermal conduction from the melt 3, and by cooling by convection of the gas in the chamber.

As mentioned above, the method using separate heaters enables maintaining a small and constant temperature gradient across the solid-liquid interface during pulling, but the control method using thermocouples placed outside the heaters is not sufficient for optimum control of the temperature gradient across the solid-liquid interface. Accordingly, the above method cannot avoid such defects as increasing the dislocation density of the single crystal and causing damage by vaporizing the volatile components (such as As and P).

Hereinafter, this invention is described in detail by an example and Figures 3 to 5c.

Figure 3 shows a cross-sectional view of an apparatus which is one of the examples of this invention.

In Figure 3, the numeral 2 is a furnace consisting of two heaters—an upper one 7 and a lower one 8.

The upper heater 7 is used mainly for heating the part of the single crystal 6 above the solid-liquid interface and the top part of the $B_2O_3$ melt 4. The lower heater 8 is used mainly for heating the raw material melt 3.

In this invention, temperature measuring is carried out by a thermocouple 9 at the seed holder 11 and a thermocouple 10 at the bottom of the crucible 1. Such temperatures are controlled as follows.

As a condition for maintaining the optimal temperature gradient across the solid-liquid interface during pulling, the temperature difference between the bottom of the crucible 1 and the seed holder 11 is intentionally varied by controlling the power supply to the upper heater 7 as a function of the length of crystal grown.

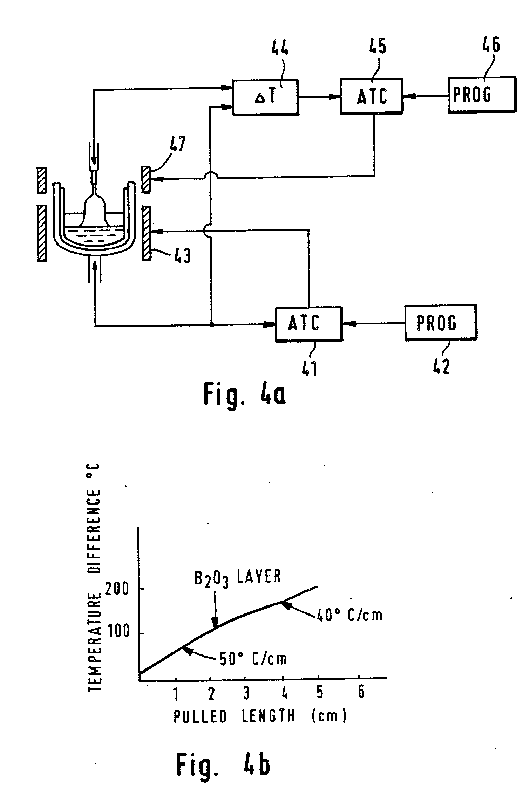

Figure 4a shows the above control technique schematically. The temperature at the bottom of the crucible is conveyed to an automatic temperature controller 41 and power is supplied to the lower heater 43 according to a base program for pulling, while a detector 44 determines the temperature difference ($\Delta T$) between the bottom of the crucible and the seed holder and conveys it to another automatic temperature controller 45 for supply of power to the upper heater 47 according to a program for controlling the upper heater temperature.

One of the patterns of the temperature difference ($\Delta T$) is shown in Figure 4b, wherein the slope of $\Delta T$ changes at the point where the top of the crystal rises above the top of the $B_2O_3$ layer.

Preferably, the slope when the top of the crystal is above the $B_2O_3$ should be smaller than the slope when the top of the crystal is within the $B_2O_3$ layer in order to slow down the cooling speed when the crystal is exposed to the convection of high-pressure gases after it rises above the layer of $B_2O_3$. The ratio is preferably at about 40°C/cm to 50°C/cm. Further, within each of these two stages, the temperature difference ($\Delta T$) is preferably changed in proportion to the pulled distance ($\Delta x$); preferably $\Delta T/\Delta x$ is in the range of 30 to 60°C/cm.

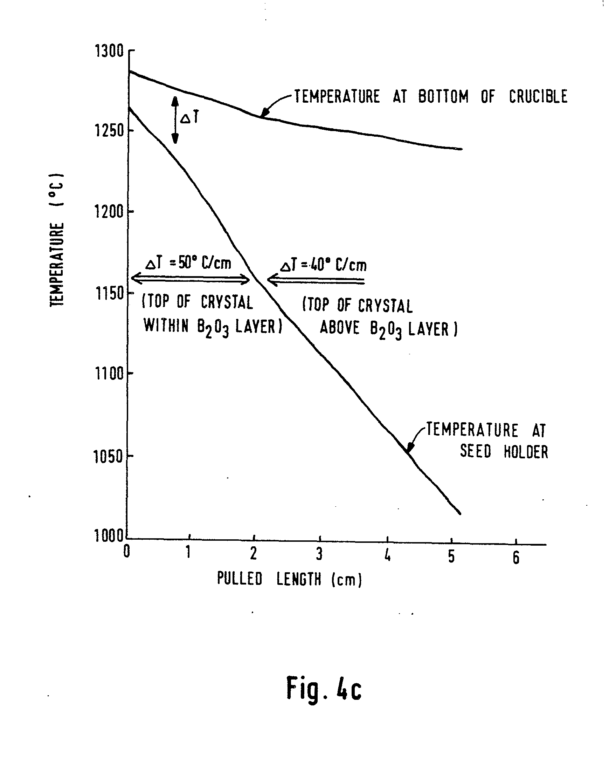

Figure 4c shows the change of temperature difference (ΔT) as pulling progresses.

Although in Figure 3 the furnace (2) consists of two heaters, this invention is not limited to the configuration described above and furnaces consisting of more than two heaters can be applied similarly.

Example A single crystal of GaAs compound was pulled by a modified LEC method utilizing this invention with two heaters. About 1.5 kg of polycrystalline material and 240 g of $B_2O_3$ were melted in a crucible of 10.16 cm (4″) diameter. During pulling, the temperature at the bottom of the crucible 1 and the temperature at the seed holder 11 were measured, and the power supplied to the upper heater 7 was controlled so that the above-mentioned temperature difference follows the pattern described in Figure 4b with the progress of drawing-up.

The 5.08 cm (2″)-diameter, 12 cm-long GaAs single crystal was grown with a pulling speed of 6 to 7 mm per hour.

For comparison, crystal growth by the other two methods was carried out. In the first method, a single heater was used as shown in Figure 1. In the other method, two heaters were used as shown in Figure 2 (conventional method).

The front part and tail part of the single crystals produced as above were cut into wafers. The surfaces of the wafers were polished and etched, and then their EPD (etch pit density) was measured.

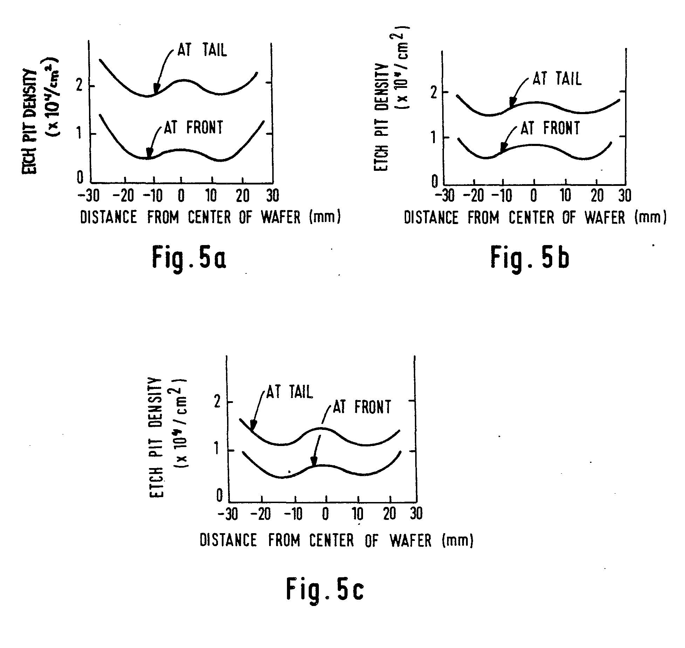

Figure 5 shows the results of the measurement: 5a, 5b, and 5c correspond to the first case wherein a single heater was used, the second conventional case wherein two heaters were used, and the third case of this invention, respectively. It can be seen from these figures that, compared with the EPD of wafers obtained by the conventional methods, the EPD of wafers obtained from the tail part of a single crystal produced by the method of this invention was greatly reduced. The EPD of case 3 is about two-thirds to one-half of the EPD of case 1 and about four-fifths to three-quarters of the EPD of case 2.

Summarizing, the method for pulling single crystals according to this invention as described above has the following advantageous effects:

① By means of using a single-crystal pulling apparatus having a furnace consisting of separately controlled heaters, measuring the temperature at the seed holder, and controlling the power supplied to the heaters so that the difference between the temperature at the crucible and the temperature at the seed holder follows a predetermined pattern as a function of the length of single crystal growth, it is possible to precisely control individual heaters so as to maintain the temperature gradient across the solid-liquid interface during pulling the single crystal. Therefore, single crystals having low dislocation density throughout the crystal can be obtained.

② Because the temperature at the seed holder is always monitored and controlled, it is also possible to control it in order to significantly reduce the vaporizing of volatile components (for example, As, P, etc.) from the surface of the single crystal, and thus there are fewer defects in the crystal structure.

**Claims**

1. Method for pulling single crystals (6) by the Czochralski technique using a single-crystal pulling apparatus having a furnace (2) consisting of separately controlled heaters (7, 8), wherein the temperature at the seed holder (11) is measured and power is supplied to the heaters (7, 8) so that the temperature difference (ΔT) between the crucible (1) and the seed holder (11) follows a predetermined pattern as a function of the pulled-up length (Δx).

2. Method according to claim 1, wherein (ΔT) is in proportion to (Δx).

3. Method according to claim 2, wherein (ΔT/Δx) is within the range of 30 to 60°C/cm.

4. Method for pulling single crystals according to claims 1—3, wherein the Czochralski technique employed is a Liquid Encapsulated Czochralski (LEC) method.

5. Method according to claim 4, wherein (ΔT/Δx) at a first stage, that is when the top of the crystal is within the encapsulating layer above the molten crystal material is larger than the (ΔT/Δx) at a successive stage, that is when the top of the crystal is above the layer.

6. Method according to claim 5, wherein (ΔT/Δx) at the first stage is about 50°C/cm and the (ΔT/Δx) at the successive stage is about 40°C/cm.

7. A method for making a single crystal which comprises the steps of:

pulling a crystal by a Czochralski technique in a furnace including a crucible, a seed holder and separately controlled heaters;

monitoring the seed holder temperature during the pulling step; and

maintaining a temperature difference (ΔT) between the seed holder and the crucible in a predetermined pattern which is a function of the pulled-up length (Δx) of the crystal, by supplying power to the heaters.

8. Method according to claim 7, wherein the Czochralski technique employed is a Liquid Encapsulated Czochralski (LEC) method.

**Patentansprüche**

1. Verfahren zur Züchtung von Einkristallen (6) mittels des Czochralski-Verfahrens, gekennzeichnet durch eine Einkristall-Ziehvorrichtung mit einem Schmelzofen (2), der getrennt regelbare Heizelemente (7, 8) aufweist, wobei die Temperatur an einem Keimhalter (11) gemessen wird und den Heizelementen (7, 8) Energie derart zugeführt wird, daß die Temperatur-differenz (ΔT) zwischen dem Schmelztiegel (1) und dem Keimhalter (11) einem festgelegten Muster als Funktion der gezogenen Kristallänge ($\Delta$x) folgt.

2. Verfahren nach Anspruch 1, dadurch gekennzeichnet, daß ($\Delta$T) proportional zu ($\Delta$x) ist.

3. Verfahren nach Anspruch 2, dadurch gekennzeichnet, daß ($\Delta$T/$\Delta$x) im Bereich von 30 bis 60°C/cm ist.

4. Verfahren zur Züchtung von Einkristallen nach den Ansprüchen 1 bis 3, dadurch gekennzeichnet, daß das verwendete Czochralski-Verfahren ein flüssigkeitsgekapseltes Czochralski-Verfahren (LEC=liquid encapsulated Czochralski) ist.

5. Verfahren nach Anspruch 4, dadurch gekennzeichnet, daß ($\Delta$T/$\Delta$x) bei einer ersten Stufe, bei der die Spitze des Kristalles innerhalb der Abdeckschicht über dem geschmolzenen Kristallmaterial ist, größer ist, als das ($\Delta$T/$\Delta$x) bei einer folgenden Stufe, bei der die Spitze des Kristalles über der Schicht ist.

6. Verfahren nach Anspruch 5, dadurch gekennzeichnet, daß ($\Delta$T/$\Delta$x) an der ersten Stufe ungefähr 50°C/cm beträgt und daß ($\Delta$T/$\Delta$x) an der folgenden Stufe ungefähr 40°C/cm beträgt.

7. Verfahren zur Züchtung von Einkristallen, gekennzeichnet durch die folgenden Verfahrensschritte:

Ziehen eines Kristalles mittels des Czochralski-Verfahrens in einem Schmelzofen mit einem Schmelztiegel, einem Keimhalter und getrennt regelbaren Heizelementen;

Überwachen der Keimhaltertemperatur während des Ziehvorganges; und

Aufrechterhalten einer Temperaturdifferenz ($\Delta$T) zwischen dem Keimhalter und dem Schmelztiegel in einem festgelegten Muster, welches eine Funktion der Ziehlänge ($\Delta$x) des Kristalles ist, wobei Energie den Heizelementen zugeführt wird.

8. Verfahren zur Züchtung von Einkristallen nach Anspruch 7, dadurch gekennzeichnet, daß das verwendete Czochralski-Verfahren ein flüssigkeitsgekapseltes Czochralski-Verfahren (LEC= liquid encapsulated Czochralski) ist.

**Revendications**

1. Procédé pour le tirage de monocristaux (6) par la technique de Czochralski utilisant un appareil de tirage de monocristaux ayant un four (2) consistant en dispositifs chauffants (7, 8) régulés séparément, dans lequel on mesure la température sur le support du germe (11) et on fournit l'énergie aux dispositifs chauffants (7, 8) de telle sorte que la différence de températures ($\Delta$T) entre le creuset (1) et le support du germe (11) suive un profil prédéterminé en fonction de la longueur tirée ($\Delta$x).

2. Procédé selon la revendication 1, dans lequel ($\Delta$T) est proportionnel à ($\Delta$x).

3. Procédé selon la revendication 2, dans lequel ($\Delta$T/$\Delta$x) est dans la gamme de 30 à 60°C/cm.

4. Procédé pour le tirage de monocristaux selon les revendications 1—3, dans lequel la technique de Czochralski utilisée est une technique Czochralski à liquide d'encapsulation (LEC).

5. Procédé selon la revendication 4, dans lequel ($\Delta$T/$\Delta$x) dans un premier stade, c'est-à-dire lorsque le sommet du cristal est à l'intérieur de la couche d'encapsulation au-dessus de la matière du cristal fondue, est supérieur au ($\Delta$T/$\Delta$x) dans un stade ultérieur, c'est-à-dire lorsque le sommet du cristal est au-dessus de la couche.

6. Procédé selon la revendication 5, dans lequel ($\Delta$T/$\Delta$x) dans le premier stade est d'environ 50°C/cm et le ($\Delta$T/$\Delta$x) dans le stade ultérieur est d'environ 40°C/cm.

7. Procédé pour fabriquer un monocristal qui comprend les étapes suivantes:

on tire un cristal par une technique de Czochralski dans un four comprenant un creuset, un support de germe et des dispositifs chauffants régulés séparément;

on contrôle la température du support de germe pendant l'étape de tirage; et

on maintient une différence de températures ($\Delta$T) entre le support de germe et le creuset dans un profil prédéterminé qui est fonction de la longueur tirée ($\Delta$x) du cristal, en alimentant en énergie les dispositifs chauffants.

8. Procédé selon la revendication 7 dans lequel la technique de Czochralski utilisée est un procédé Czochralski à liquide d'encapsulation (LEC).

Fig. 1

Fig. 2

Fig. 3

Fig. 4a

Fig. 4b

Fig. 4c

Fig. 5a

Fig. 5b

Fig. 5c